# EUROPÄISCHE PATENTANMELDUNG

(11) **EP 4 312 091 A1**
(43) Veröffentlichungstag der Anmeldung: **31.01.2024**
(21) Anmeldenummer: 22187765.7
(22) Anmeldetag: 29.07.2022
(51) Int. Cl.: G05B 17/02

(54) **COMPUTERIMPLEMENTIERTES VERFAHREN UND SYSTEM ZUR ERZEUGUNG VON SIMULATIONSMODELLEN FÜR EINEN DIGITALEN ZWILLING EINES PROZESSES EINER PRODUKTIONSANLAGE FÜR EIN PRODUKT**

(71) Anmelder: Siemens Aktiengesellschaft, 80333 München (DE)
(72) Erfinder: Pfeiffer, Bernd-Markus, 91080 Uttenreuth (DE)
(74) Vertreter: Siemens Patent Attorneys

(57) **Zusammenfassung**

Erfindungsgemäß wird für einen digitalen Zwilling eines Prozesses einer Produktionsanlage ein stationäres flussgetriebenes Simulationsmodell (41) des Prozesses (3) und daraus wiederum ein stationäres druckgetriebenes Simulationsmodell (51) des Prozesses (3) erzeugt. Aus letzterem Modell wird ein dynamisches druckgetriebenes Simulationsmodells (61) des Prozesses erzeugt, welches Sensoren und Aktoren von Regelkreisen der Anlage umfasst. Jedes der Simulationsmodelle (41, 51, 61, 71) ermittelt messbare Zustandsgrößen (T) der Produktionsanlage (1), vorzugsweise auch Kennzahlen (Q) einer Qualität des Produktes (S), in Abhängigkeit von der Produktionsanlage (1) zugeführten Stoffströmen von Edukten (E) und von Betriebs-Medien (B). Modelldaten (MD) von jedem der Simulationsmodelle (41, 51, 61, 71) werden derart erzeugt und in einem Datenspeicher (125) abgespeichert, dass sie durch eine Simulationssoftware (126) auslesbar und daraus die Simulationsmodelle (41, 51, 61, 71) zur Ausführung bringbar sind.

Es kommt somit zu einer durchgängigen Nutzung des stationären flussgetriebenen Simulationsmodells für einen digitalen Prozess-Zwilling. Dieses Modell wird kontinuierlich weiterentwickelt und auf den jeweiligen Anwendungsfall angepasst, ohne Informationen aus früheren Phasen zu verlieren oder erneut manuell einpflegen zu müssen. Eine Entwicklung eines digitalen Prozess-Zwillings kann damit über mehrere Anwendungsfälle amortisiert werden.

## Beschreibung

Die Erfindung betrifft ein computerimplementiertes Verfahren und ein System zur Erzeugung von Simulationsmodellen für einen digitalen Zwilling eines verfahrenstechnischen Prozesses einer Produktionsanlage für ein Produkt gemäß Patentanspruch 1 bzw. 12.

Produktionsanlagen auf Basis verfahrenstechnischer Prozesse dienen der Erzeugung sowie der Umwandlung von Produkten (bzw. Stoffen) mit nicht genau definierter Form. Derartige Anlagen kommen vor allem in der Prozess-Industrie zum Einsatz, z.B. in der Papier-, Chemie-, Pharma-, Metall-, Öl- und Gas-Industrie. Es handelt sich in der Regel um sehr komplexe Anlagen mit einer Vielzahl von Betriebsarten, einer großen räumlichen Ausdehnung und einem Zusammenwirken einer Vielzahl von Komponenten. Zur Bedienung und Beobachtung sowie zur Steuerung/Regelung des verfahrenstechnischen Prozesses umfassen diese Anlagen meistens ein Prozessleitsystem. Beispiele hierfür sind die Prozessleitsysteme PCS 7 und PCS neo der Anmelderin.

Zunehmend kommen dabei auch sogenannte "digitale Zwillinge" des verfahrenstechnischen Prozesses zum Einsatz. Ein solcher digitaler Zwilling umfasst in der Regel Planungsdaten aus der Design- und Engineering-Phase des Prozesses sowie Daten aus der Betriebsphase, aber auch Verhaltensbeschreibungen in Form von Simulationsmodellen. Ein solcher "Digital Process Twin" kann für verschiedene Anwendungsfälle im Lebenszyklus einer Produktionsanlage genutzt werden.

Der Artikel "Evolution eines Digital Twin am Beispiel einer Ethylen-Anlage - Konzept und Umsetzung" von Labisch D., Leingang C., Lorenz O., Oppelt M., Pfeiffer B.-M., Pohmer F. in "atp magazin" 06-07/2019, Seiten 70 bis 85, beschreibt ein Konzept für die Entwicklung und durchgängige Nutzung eines Digital Twins über den gesamten Lebenszyklus einer Prozessanlage. Es wird dabei der Ansatz verfolgt, die einzelnen Modelle und Softwarewerkzeuge zu einem durchgängigen, semantisch gekoppelten System zu integrieren, durchgängig über die verschiedenen Hierarchieebenen einer Anlage und über die verschiedenen Phasen im Lebenszyklus der Anlage. Der Einsatz von Simulation wird dabei in Bezug auf die Phasen des Anlagenlebenszyklus in die vier Gruppen Planungs-Simulation, Virtuelle Inbetriebnahme-Simulation, Trainings-Simulation und betriebsbegleitende Simulation (Soft Sensor, Model Predictive Control) unterteilt. Dabei wird ein Bild der Zukunft gezeichnet, bei dem einmal entwickelte Modelle wiederverwendet werden und im Laufe des Lebenszyklus verfeinert werden.

Das Konzept wird am Beispiel eines Steam Crackers erläutert. Am Beginn des Lebenszyklus einer Anlage steht das Anlagen-Design. Hier wird auf Basis von bereits bestehendem Anlagenwissen und aktuellen Erkenntnissen aus Veröffentlichungen ein erster "Digital-Process-Twin" mit einer Simulations-Software erstellt. Dieser Digital Twin dient der Auslegung der Anlage und ihrer Komponenten (Conceptual Design). Darunter fällt beispielsweise für einen Cracker die Festlegung der chemischen Reaktion oder die Ermittlung der optimalen Reaktorgrößen und Wanddicken. Auch die Dimensionierung von Pumpen, Wärmetauschern und Pufferbehältern erfolgt mithilfe stationärer Simulationsmodelle. Im weiteren Verlauf des Engineerings wird der mit der Simulations-Software erzeugte Digital-Process-Twin in Form eines Verfahrensfließbildes (Process Flow Diagram) in das Anlagenplanungstool übertragen und stellt damit die Grundlage für einen "Digital-Plant-Twin" dar. Dieser wird sukzessive um weitere anlagenrelevante Aspekte, zum Beispiel Sensoren, Aktoren und Reglerstrukturen erweitert. Als Resultat erhält man das Rohrleitungs- und Instrumentierungs-Fließschema (R&I, englisch: piping and instrumentation diagram, P&ID). Die Analyse und Validierung der Reglerkonzepte findet parallel dazu mit einem dynamischen Simulationsmodell statt, das heißt, die beiden Digital Twins werden kontinuierlich miteinander synchronisiert. Änderung im Digital-Plant-Twin wirken sich direkt auf den Digital-Process-Twin aus. Fehler im Anlagen-Design können anhand der Simulation des dynamischen Modells frühzeitig identifiziert und behoben werden.

Ein "Digital-Instrumentation-Twin" wird dazu verwendet, ein erstelltes Automatisierungsprogramm im Rahmen einer virtuellen Inbetriebnahme zu validieren und Fehlverhalten vor der realen Inbetriebnahme zu identifizieren. Für ein Trainings-system für Bediener der Anlage wird der "Digital Process Twin" an ein Simulationsmodell des "Digital-Instrumentation-Twin" angekoppelt. Eine detaillierte Prozesssimulation, die bereits im Conceptual Design in einer verfahrenstechnischen Simulationssoftware erstellt wird, kann somit über den gesamten Lebenszyklushinweg genutzt werden.

In Tabelle 1 des Artikels werden verschiedene Komponenten eines Digital Twin mit ihrem Einsatzzweck dargestellt. Beispielsweise kann ein dynamisches vereinfachtes linearisiertes Modell einer Unit (Reaktor, Cracker) im Lebenszyklus für folgende Aufgaben verwendet werden: Planung des Automatisierungskonzepts (PID-Reglerentwurf), virtuelle Inbetriebnahme, reale Inbetriebnahme (Nutzung oder Aktualisierung des Modells für das PID-Tuning), Optimierung in der Betriebsphase (MPC) und Regelkreisüberwachung (CPM). Dazu wird das Modell in verschiedene Software-Tools transferiert beziehungsweise dort aktualisiert.

Ein genaues rigoroses dynamisches Modell ist in dem Simulationswerkzeug gPROMS von Siemens Process Systems Engineering Ltd. realisiert und kann für die Planung von Fahrweisen (Rezepten) im Detailed Engineering, für die Planung von Automatisierungskonzepten, in der Betriebsphase für Schulungszwecke und modellbasierte Soft-Sensoren genutzt werden.

Am Beispiel einer Unit wird im Rahmen des Basic Engineering zunächst ein rigoroses stationäres Modell entwickelt. Sobald dynamikrelevante Kenngrößen wie Behältervolumina, Wärmekapazitäten, Pumpenleistungen etc. bekannt sind, kann daraus ein grobes dynamisches Modell abgeleitet werden, das bereits eine Wasserfahrt simulieren kann. Dieses wird verfeinert zu einem genauen dynamischen Modell, in welchem beispielsweise auch chemische Reaktionen mit ihrer Reaktionskinetik dargestellt sind. Vereinfachte dynamische Modelle für regelungstechnische Zwecke können aus dem rigorosen dynamischen Modell extrahiert werden.

Zum Stand der Technik wird weiterhin verwiesen auf den Artikel Busse, C., Bozek, E., Pfeiffer, B-M., Leingang, Ch., Roth, M., Krauß, M., Schulz, Ch., Oppelt, M.: "Integration digitaler Technologien für das Engineering, den Betrieb und die Instandhaltung einer verfahrenstechnischen Anlage" in Chemie Ingenieur Technik 92(9):1250-1250, Sep. 2020.

Außerdem wird verwiesen auf den Artikel Pfeiffer, B-M., Oppelt, M., Leingang, Ch., Pantelides, C., Pereira, F.: "Nonlinear Model Predictive Control based on Existing Mechanistic Models of Polymerisation Reactors" in IFAC World Congress 2020, Berlin (virtuell), Jul. 2020.

Ausgehend hiervon ist es Aufgabe vorliegender Erfindung, ein computerimplementiertes Verfahren und ein System anzugeben, die eine aufwandsarme Erzeugung von Simulationsmodellen für einen digitalen Zwillinge eines verfahrenstechnischen Prozesses einer Produktionsanlage entlang deren Lebenszyklus ermöglichen.

Die Lösung dieser Aufgabe gelingt durch ein computerimplementiertes Verfahren gemäß Patentanspruch 1 sowie ein System gemäß Patentanspruch 12. Ein Computerprogramm, umfassend Befehle, die bei der Ausführung des Programms durch einen Computer diesen veranlassen, das erfindungsgemäße Verfahren auszuführen, ist Gegenstand des Patentanspruchs 13. Ein computerlesbares Speichermedium umfassend Befehle, die bei der Ausführung durch einen Computer diesen veranlassen, das erfindungsgemäße Verfahren auszuführen, ist Gegenstand des Patentanspruchs 14. Vorteilhafte Ausgestaltungen sind jeweils Gegenstand der Unteransprüche.

Das erfindungsgemäße computerimplementierte Verfahren zur Erzeugung von Simulationsmodellen für einen digitalen Zwilling eines Prozesses einer verfahrenstechnischen Produktionsanlage für ein Produkt umfasst:
a) Empfangen von Verfahrensfluss-Planungsdaten (z.B. aus einem Verfahrensfließschema, engl. Process Flow Diagram) des Prozesses der Produktionsanlage,
b) Erzeugen eines stationären flussgetriebenen Simulationsmodells des Prozesses aus den Verfahrensfluss-Planungsdaten,
c) Erzeugen eines stationären druckgetriebenen Simulationsmodells des Prozesses aus dem stationären flussgetriebenen Simulationsmodell,
d) Empfangen von Rohrleitungs- und Instrumentierungs-Planungsdaten (z.B. aus einem R&I-Diagramm, engl. P&I-Diagram) der Produktionsanlage,
e) Erzeugen eines dynamischen druckgetriebenen Simulationsmodells des Prozesses aus dem stationären druckgetriebenen Simulationsmodell und den Rohrleitungs- und Instrumentierungs-Planungsdaten, wobei das dynamische druckgetriebene Simulationsmodell Sensoren und Aktoren von Regelkreisen der Anlage umfasst.

Dabei werden für jedes der Simulationsmodelle messbare Zustandsgrößen der Produktionsanlage, vorzugsweise auch Kennzahlen einer Qualität des Produktes, in Abhängigkeit von Stoffströmen von Edukten (z.B. Kohlenwasserstoffe) und Betriebs-Medien (z.B. Heizdampf, Kühlwasser), die der Produktionsanlage zugeführt werden, ermittelt.

Weiterhin werden Modelldaten von jedem der Simulationsmodelle (d.h. Daten, die die Simulationsmodelle beschreiben bzw. definieren) derart erzeugt (z.B. hinsichtlich Auswahl, Inhalt, Struktur) und in einem Datenspeicher abgespeichert, dass durch eine Simulationssoftware die Modelldaten auslesbar und anhand der ausgelesenen Modelldaten die Simulationsmodelle zur Ausführung bringbar sind.

Erfindungsgemäß wird somit ein erstes Simulationsmodell des Prozesses, hier das stationäre flussgetriebene Simulationsmodell des Prozesses, durch eine Modell-Transformationen in andere Simulationsmodelle des Prozesses umgewandelt. Die Modell-Transformation ermöglicht eine durchgängige Nutzung des ersten Simulationsmodells des Prozesses in einem digitalen Zwilling des Prozesses ("Digital Process Twin") für verschiedene Anwendungsfälle im Lebenszyklus einer Anlage. Wie sich herausgestellt hat, können mit der erfindungsgemäßen Modell-Transformation (siehe Schritte b), c), e)) die wichtigsten Anwendungsfälle für einen digitalen Zwilling eines Produktionsprozesses abgedeckt werden.

Erfindungsgemäß ermittelt dabei jedes der Simulationsmodelle messbare Zustandsgrößen (z.B. Temperaturen, Drücke, Füllstände, pH-Werte, etc.) der Produktionsanlage, vorzugsweise auch Kennzahlen einer Qualität des Produktes, in Abhängigkeit von Stoffströmen von Edukten und von Betriebs-Medien, die der Produktionsanlage zugeführt werden. Auch hier liegt die Erkenntnis zugrunde, dass gerade mit diesen Größen die wichtigsten Anwendungsfälle für einen digitalen Zwilling bei einem Produktionsprozess abgedeckt werden können: die messbaren Zustandsgrößen beschreiben den Zustand der Produktionsanlage bzw. den Produktionsprozess und die Produktqualität ist das maßgebliche Kriterium für den Erfolg des Prozesses. Da die meisten Vorgänge in einer Produktionsanlage "nichtlineare" Vorgänge sind, handelt es sich bei den Simulationsmodellen vorzugsweise um nichtlineare Modelle. Beispielsweise hängt der Durchfluss durch ein Ventil oft nichtlinear von der Ventilstellung ab. Druck oder Förderhöhe einer Kreiselpumpe hängen quadratisch von der Pumpendrehzahl ab. Die Geschwindigkeit einer chemischen Reaktion hängt immer nichtlinear von der Temperatur ab.

Unter einer "flussgetriebenen" Simulation wird dabei eine Simulation verstanden, bei der Durchflüsse beginnend von der Edukt-Zufuhr her spezifiziert werden und eine Druckverteilung im Flussnetz und Durchflüsse unabhängig voneinander berechnet werden.

Unter einer "druckgetriebenen" Simulation wird eine Simulation verstanden, bei der ein Edukt aus einer Quelle (z.B. einer Versorgungsleitung) mit definiertem Druck bezogen wird und sich ein Durchfluss in jeder Komponente des Flussnetzes aus Druckdifferenz und Strömungswiderstand ergibt.

Gemäß einer vorteilhaften Ausgestaltung des erfindungsgemäßen Verfahrens umfasst das in dem Schritt e) erzeugte dynamische druckgetriebene Simulationsmodell bereits auch schon Aktoren von Folgeregelkreisen, insbesondere strömungsmechanische Modelle von Aktoren von Folgeregelkreisen, der Regelkreise, oder es wird in einem weiteren Schritt f) um diese erweitert. Hierdurch kann die Zahl der Anwendungsfälle des digitalen Prozess-Zwillings noch weiter vergrößert werden.

Gemäß einer weiteren vorteilhaften Ausgestaltung des erfindungsgemäßen Verfahrens umfasst das in dem Schritt e) oder f) erzeugte dynamische druckgetriebene Simulationsmodell bereits auch schon PID-Regler der Regelkreise, oder es wird in einem weiteren Schritt g) um diese erweitert. Auch hierdurch kann die Zahl der Anwendungsfälle des digitalen Prozess-Zwillings noch weiter vergrößert werden.

Das in dem Schritt b) und/oder c) erzeugte Simulationsmodell kann dann vorteilhaft für eine verfahrenstechnische Auslegung der Produktionsanlage verwendet und die Produktionsanlage entsprechend dieser Auslegung physikalisch realisiert werden.

Das in dem Schritt e), f) oder g) erzeugte Simulationsmodell kann von Vorteil für eine Entwicklung und Validierung von Regelungskonzepten verwendet und die Regelung der Produktionsanlage dann entsprechend dieser Auslegung physikalisch realisiert werden.

Das in dem Schritt e), f) oder g) erzeugte Simulationsmodell wird bevorzugt für eine virtuelle Inbetriebnahme der Anlage verwendet und hierzu mit einer Steuerungs-Software der Anlage gekoppelt, um diese auf Fehlerfreiheit zu testen. Informationen über einen Fehler oder über eine Fehlerfreiheit können dann auf einer Ausgabeeinheit (z.B. einer Anzeige) zur Ausgabe gebracht werden. Im Fall eines Fehlers kann die Steuerungs-Software dann korrigiert werden.

Das in dem Schritt e), f) oder g) erzeugte Simulationsmodell kann für ein Training von Bedienpersonal der Anlage verwendet und hierzu mit einer Bedien- und Beobachtungs-Software der Anlage gekoppelt werden.

Gemäß einer weiteren vorteilhaften Ausgestaltung wird das in dem Schritt e), f) oder g) erzeugte Simulationsmodell für einen modellbasierten Soft-Sensor der Anlage verwendet. Ein Softsensor erhält eingangsseitig Messgrößen der Anlage und ermittelt daraus nicht (oder nur schwer) messbare Größen der Anlage, bei einem Produktionsprozess für ein Produkt vor allem Kennzahlen zur Produktqualität.

Das in dem Schritt e), f) oder g) erzeugte Simulationsmodell kann von Vorteil auch für eine modellbasierte prädiktive Regelung der Anlage verwendet werden.

Gemäß einer weiteren vorteilhaften Ausgestaltung wird das in dem Schritt e), f) oder g) erzeugte Simulationsmodell für ein Assistenzsystem für den Bediener der Anlage verwendet und hierzu mit einer Steuerungs-Software der Anlage gekoppelt.

Ein erfindungsgemäßes System zur Erzeugung von Simulationsmodellen für einen digitalen Zwilling eines Prozesses einer verfahrenstechnischen Produktionsanlage für ein Produkt, umfasst
- eine Schnittstelle, die ausgebildet ist
   a) zum Empfang von Verfahrensfluss-Planungsdaten und von Rohrleitungs- und Instrumentierungs-Planungsdaten der Produktionsanlage und
   b) zur Ausgabe von Modelldaten von jedem der Simulationsmodelle zu deren Speicherung in einem Datenspeicher,
- einen Speicher, umfassend Befehle,
- einen Prozessor, der mit dem Speicher gekoppelt ist und bei Ausführung der Befehle ausgebildet ist, die Schritte a) bis e), vorzugsweise auch die weiteren Schritte f) und/oder g), des vorstehend beschriebenen Verfahrens auszuführen, wobei jedes der Simulationsmodelle messbare Zustandsgrößen der Produktionsanlage, vorzugsweise auch Kennzahlen einer Qualität des Produktes, in Abhängigkeit von der Produktionsanlage zugeführten Stoffströmen von Rohstoffen und BetriebsMedien ermittelt, und wobei die Modelldaten derart erzeugt sind, dass anhand der Modelldaten die Simulationsmodelle durch eine Simulationssoftware zur Ausführung bringbar sind.

Ein erfindungsgemäßes Computerprogramm umfasst Befehle, die bei der Ausführung des Programms durch einen Computer diesen veranlassen, das vorstehend beschriebene Verfahren auszuführen.

Ein erfindungsgemäßes computerlesbares Speichermedium umfasst Befehle, die bei der Ausführung durch einen Computer diesen veranlassen, das vorstehend beschriebene Verfahren auszuführen.

Die für das erfindungsgemäße Verfahren genannten Vorteile und vorteilhaften Ausgestaltungen gelten in entsprechender Weise auch für das erfindungsgemäße System.

Die Erfindung sowie weitere vorteilhafte Ausgestaltungen der Erfindung gemäß Merkmalen der Unteransprüche werden im Folgenden anhand von Ausführungsbeispielen in den Figuren näher erläutert. Dabei sind einander entsprechende Teile mit jeweils gleichen Bezugszeichen versehen. Es zeigen:
- FIG 1: einen beispielhaften prinzipiellen Aufbau einer verfahrenstechnischen Produktionsanlage für ein Produkt,
- FIG 2: einen Spaltofen (Steam Cracker) als Beispiel für eine verfahrenstechnische Produktionsanlage,
- FIG 3: einen erfindungsgemäßen Verfahrensablauf,
- FIG 4 und 5: eine schematische Darstellung eines digitalen Prozess-Zwillings für eine verfahrenstechnische Auslegung einer Anlage,
- FIG 6: eine schematische Darstellung eines digitalen Pro-zess-Zwillings für eine Entwicklung und Validierung von Regelungskonzepten,
- FIG 7: eine schematische Darstellung eines digitalen Pro-zess-Zwillings für eine virtuelle Inbetriebnahme der Anlage,
- FIG 8: eine schematische Darstellung eines digitalen Pro-zess-Zwillings für ein Training von Bedienpersonal der Anlage,
- FIG 9: eine schematische Darstellung eines digitalen Pro-zess-Zwillings für einen modellbasierten Soft-Sensor der Anlage,
- FIG 11: eine schematische Darstellung eines digitalen Pro-zess-Zwillings für eine modellbasierte prädiktive Regelung der Anlage,
- FIG 12: ein erfindungsgemäßes System in schematischer Darstellung.

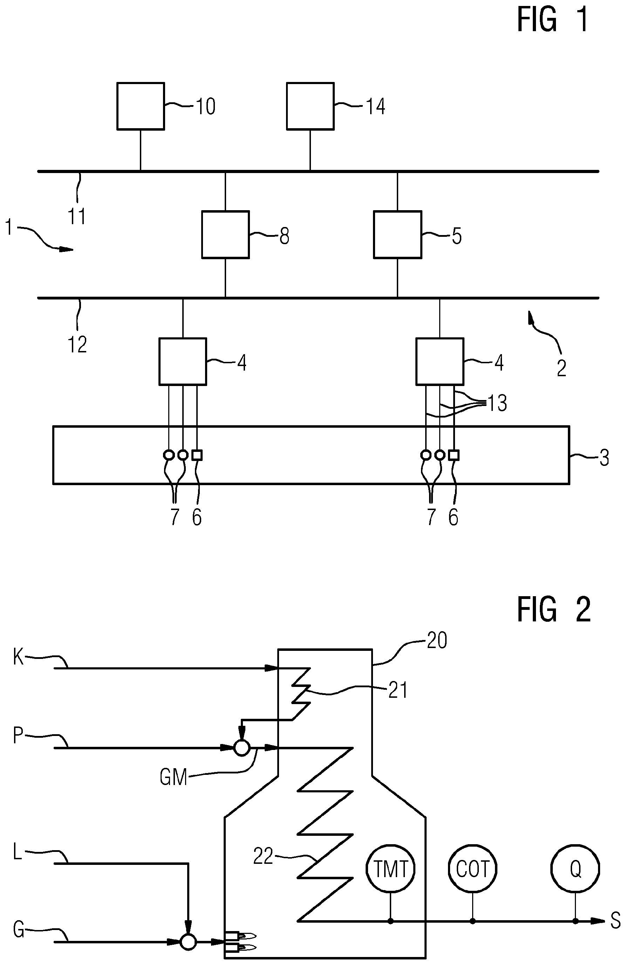

FIG 1 zeigt in vereinfachter und beispielhafter Darstellung eine verfahrenstechnische Produktionsanlage 1 für ein Produkt mit einem Automatisierungssystem 2 zur Steuerung und/oder Regelung eines Produktionsprozesses 3. Unter dem Begriff "Produktionsprozess" wird hierbei nicht nur ein Erzeugungsprozess, sondern auch ein Bearbeitungs-, Verarbeitungs- oder Umwandlungsprozess (z.B. auch ein Energieerzeugungsprozess) verstanden.

Derartige Anlagen 1 kommen in verschiedensten Industriesektoren zum Einsatz, zum Beispiel in der Prozess-Industrie (z.B. Papier, Chemie, Pharma, Metall, Öl- und Gas) und in der Energieerzeugung. Das Automatisierungssystem 2 umfasst beispielsweise mehrere industrielle Steuerungen 4, einen Automatisierungs-Server 5 und einen Engineering-Server 8.

Jede der Steuerungen 4 steuert den Betrieb jeweils eines Teilbereichs des Prozesses 3 in Abhängigkeit von dessen Betriebszuständen. Der Prozess 3 umfasst hierzu von den Steuerungen 4 ansteuerbare Aktoren 6. Hierbei kann es sich um einzelne Aktoren (z.B. einen Motor, eine Pumpe, ein Ventil, ein Schalter), um Gruppen derartiger Aktoren oder um ganze Sektionen einer Anlage handeln. Weiterhin umfasst der Prozess Sensoren 7, die den Steuerungen 4 Messwerte von Prozessgrößen (z.B. Temperaturen, Drücke, Füllstände, Durchflüsse) zur Verfügung stellen.

Ein Kommunikationsnetzwerk der Anlage 1 umfasst auf einer übergeordneten Ebene ein Anlagen-Netzwerk 11, über das die Server 5, 8 mit einer Mensch-Maschinen-Schnittstelle (HMI) 10 in Kommunikation stehen, und ein Steuerungs-Netzwerk 12, über das die Steuerungen 4 miteinander und mit den Servern 5, 8 in Kommunikationsverbindung stehen. Die Verbindung der Steuerungen 4 mit den Aktoren 6 und Sensoren 7 kann über diskrete Signalleitungen 13 oder über einen Feldbus erfolgen. Die Mensch-Maschinen-Schnittstelle (HMI) 10 ist üblicherweise als Bedien- und Beobachtungsstation ausgebildet und in einer Leitwarte der Anlage 1 angeordnet.

Bei dem Automatisierungs-Server 5 kann es sich zum Beispiel um einen sogenannten "Operator-System-Server" oder "Anwendungs-Server" (Application-Server) handeln, in dem ein oder mehrere anlagenspezifische Anwendungsprogramme gespeichert sind und beim Betrieb der Anlage 1 zur Ausführung gebracht werden. Diese dienen beispielsweise dazu, in der Anlage 1 die Steuerungen 4 zu konfigurieren, Bediener-Aktivitäten an der Mensch-Maschine-Schnittstelle (HMI) 10 zu erfassen und auszuführen (z.B. Sollwerte von Prozessvariablen einzustellen oder zu ändern) oder Meldungen für Anlagenpersonal zu erzeugen und auf der Mensch-Maschine-Schnittstelle (HMI) 10 zur Anzeige zu bringen.

Das Automatisierungssystem 2 ohne die Feldgeräte (d.h. ohne Aktoren 6 und Sensoren 7) wird häufig auch als "Prozessleitsystem" bezeichnet.

In großen industriellen Produktionsanlagen ist eine Vielzahl der vorstehend beschriebenen Komponenten im Einsatz. Manchmal können auch gleichzeitig mehrere Produktionsprozesse 3 zur Ausführung gebracht werden. Die Sensoren 7 stellen deshalb eine Vielzahl von Messdaten von Prozessgrößen des Prozesses 3 bereit. Diese Messdaten werden auf einem Prozessdatenarchiv-Server 14 zusammen mit Meldungen des Automatisierungs-Server 5 sowie mit Zusatzinformationen (z.B. Chargendaten, Zustandsinformationen intelligenter Feldgeräte) gespeichert.

Wie anhand FIG 2 dargestellt ist, kann es sich bei dem Prozess 3 beispielsweise um eine Dampfspaltung (englisch: steam cracking) handeln. Dampfspaltung ist ein Verfahren der Petrochemie, bei dem langkettige Kohlenwasserstoffe (Naphtha, aber auch Ethan, Propan und Butan) durch thermische Spaltung in Gegenwart von Wasserdampf in kurzkettige Kohlenwasserstoffe wie Ethylen, Propylen und Buten umgewandelt werden.

Die Dampfspaltung erfolgt in einem Spaltofen (engl. Steam cracker) 20, der schematisch in Bild 2 mit den wichtigsten Materialströmen dargestellt ist. Er dient zur Herstellung von Zwischenprodukten, die hauptsächlich zu Kunststoffen (beispielweise Polyethylen), Lacken, Lösungsmitteln oder Pflanzenschutzmitteln verarbeitet werden. Beim Spaltofen 20 handelt es sich um einen Rohrreaktor, dem Kohlenwasserstoffe K als Edukt und Prozessdampf P, Luft L und Brenngas G als Betriebsmedien zugeführt werden. Die Kohlenwasserstoffe K und das Gemisch GM aus Kohlenwasserstoff K und Prozessdampf P wird mittels Rohrbündeln 21, 22 erhitzt. Dabei werden die langkettigen Moleküle innerhalb von Sekundenbruchteilen thermisch gespalten. In Bild 2 ist vereinfacht nur ein einzelner Rohrstrang dargestellt. COT (Coil Outlet Temperature) und TMT (Tube Metal Temperature) beschreiben Temperaturen und somit Zustandsgrößen des Spaltofens 20. Als Ausgangsprodukt am Spaltofen 20 entsteht Spaltgas S, dessen Qualität Q mit Hilfe eines Mesgerätes gemessen werden kann.

Eine Mehrzahl derartiger Spaltöfen 20 kann beispielsweise am Anfang im Materialfluss einer Ethylen-Anlage angeordnet sein. Mehrere große Spaltöfen 20 werden dann parallel betrieben. In einem nachgelagerten, mehrstufigen Trennprozess mit Destillationskolonnen, Dampfabscheidern, Kühlern und ähnlichen Apparaten werden dann verschiedene nutzbare Produkte abgetrennt.

Ein sogenannter "digitaler Zwilling" des Prozesses 3 der verfahrenstechnischen Anlage 1 von FIG 1, oder beispielhaft des Dampfspaltungsprozesses in dem Spaltofen 20 von FIG 2, kann in verschiedenen Phasen des Anlagenlebenszyklus gewinnbringend eingesetzt werden. Der "digitale Zwilling" des Prozesses wird im Weiteren auch als "digitaler Prozess-Zwilling" (engl. Digital Process Twin) bezeichnet. Er umfasst in der Regel Planungsdaten aus der Design- und Engineering-Phase sowie Anlagendaten aus der Betriebsphase, aber auch Verhaltensbeschreibungen in Form von Modellen, insbesondere mathematischer Modelle. Der digitale Zwilling entwickelt sich entlang des Anlagen-Lebenszyklus und integriert in jedem Schritt vorhandene Daten und Wissensgrundlagen.

Die Erfindung öffnet nun den Weg zur durchgängigen Nutzung eines digitalen Prozess-Zwillings für verschiedene Anwendungsfälle im Lebenszyklus einer Anlage durch eine sukzessive Modell-Transformation. Neben der Verhaltensbeschreibung des eigentlichen verfahrenstechnischen Prozesses wird dabei auch die Basisautomatisierung der Anlage mit Hilfe zahlreicher PID-Regler bei den verschiedenen Modelltransformationen berücksichtigt und erfordert spezielle Aufmerksamkeit: die Dynamik der Regler, ihre logischen Zusatzfunktionen und ihre Rolle im Kontext der aufgeführten Anwendungsfälle. Im Folgenden werden mehrere Anwendungsfälle ("Use Cases") der Reihe nach betrachtet, und die erforderlichen Modell-Transformationen beschrieben. Dabei ist berücksichtigt, dass unterschiedliche Anwendungsfälle auch unterschiedliche Anforderungen an den digitalen Prozess-Zwilling stellen. Der Aufwand für die Erzeugung eines digitalen Prozess-Zwillings lässt sich nun vorteilhaft über mehrere Anwendungsfälle amortisieren.

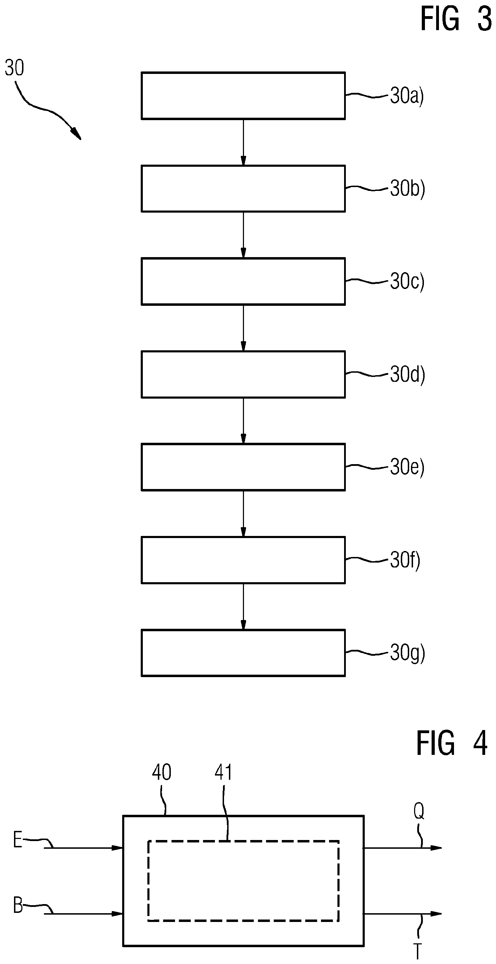

Gemäß FIG 3 umfasst ein erfindungsgemäßes computerimplementiertes Verfahren 30 zur Erzeugung von Simulationsmodellen für digitale Zwillinge eines Prozesses einer verfahrenstechnischen Produktionsanlage für ein Produkt die folgenden Schritte:
- in einem ersten Schritt 30 a): Empfangen von Verfahrensfluss-Planungsdaten (z.B. zu dem Verfahrensfließschema, engl. Process Flow Diagram) des Prozesses der Produktionsanlage,
- in einem zweiten Schritt 30 b): Erzeugen eines stationären flussgetriebenen Simulationsmodells des Prozesses aus den Verfahrensfluss-Planungsdaten,
- in einem dritten Schritt 30 c): Erzeugen eines stationären druckgetriebenen Simulationsmodells des Prozesses aus dem stationären flussgetriebenen Simulationsmodell,
- in einem vierten Schritt 30 d): Empfangen von Rohrleitungs- und Instrumentierungs-Planungsdaten (z.B. aus einem R&I-Diagramm, engl. P&I-Diagram) der Produktionsanlage,
- in einem fünften Schritt 30 e): Erzeugen eines dynamischen druckgetriebenen Simulationsmodells des Prozesses aus dem stationären druckgetriebenen Simulationsmodell und den Rohrleitungs- und Instrumentierungs-Planungsdaten, wobei das dynamische druckgetriebene Simulationsmodell Sensoren und Aktoren von Regelkreisen der Produktionsanlage umfasst,
- in einem sechsten Schritt 30 f): Erweitern des dynamischen druckgetriebenen Simulationsmodells des Prozesses um Aktoren von Folgeregelkreisen, insbesondere um strömungsmechanische Modelle von Aktoren von Folgeregelkreisen, der Produktionsanlage,
- in einem siebten Schritt 30 g): Erweitern des dynamischen druckgetriebenen Simulationsmodells von Schritt 30 f) um PID-Regler der Regelkreise der Produktionsanlage.

Dabei ermittelt jedes der Simulationsmodelle Kennzahlen einer Qualität des Produktes und messbare Zustandsgrößen der Produktionsanlage in Abhängigkeit von der Produktionsanlage zugeführten Stoffströmen von Edukten und von Betriebs-Medien.

Modelldaten von jedem der Simulationsmodelle (d.h. Daten, die die Simulationsmodelle beschreiben bzw. definieren) werden derart erzeugt (z.B. hinsichtlich Auswahl, Inhalt, Struktur) und in einem Datenspeicher abgespeichert, dass durch eine Simulationssoftware die Modelldaten auslesbar und anhand der ausgelesenen Modelldaten die Simulationsmodelle zur Ausführung bringbar sind.

Wie anhand von FIG 3 und 4 veranschaulicht ist, werden als Ausgangspunkt in dem Schritt 30 a) Verfahrensfluss-Planungsdaten (z.B. aus einem Verfahrensfließschema, Process Flow Diagram) des Prozesses der Produktionsanlage empfangen und daraus in dem Schritt 30 b) ein stationäres flussgetriebenes Simulationsmodell 41 für einen geplanten Arbeitspunkt des Prozesses erzeugt. Beispielsweise wird ausgehend vom PFD (Process Flow Diagramm) das Flussnetz in einem Simulations-Tool aufgebaut, soweit möglich durch Verbindung von vorhandenen Komponentenmodellen (Rührkesselreaktoren, Destillationskolonnen, Wärmetauschern, Tanks etc.) aus Modellbibliotheken mit Stoffstrom-Verbindungen (Rohrleitungen ohne Strömungswiderstand), Verzweigungen und Mixern. Das Flussnetz wird zuerst als stationäre flussgetriebene Simulation gerechnet, d.h. die Durchflüsse werden beginnend von der Rohstoffzufuhr her spezifiziert, und die Druckverteilung im Flussnetz und die Durchflüsse unabhängig voneinander berechnet.

Diese Simulationen dienen der Auslegung und Auswahl von Anlagen-Komponenten wie Reaktoren, Kolonnen, Pumpen, Wärmetauschern etc. In dieser Phase ist beispielsweise ein Zulauf zu einem Spaltofen im Simulationsmodell lediglich als Materialfluss-Quelle mit definierten Stoffkonzentrationen und Nenn-Durchfluss dargestellt.

Der digitale Prozess-Zwilling 40 umfasst das Simulationsmodell 41 und hat als Eingangsgrößen für das Simulationsmodell 41 Werte für die dem Prozess bzw. der Produktionsanlage zugeführten Stoffströme von Edukten E und von Betriebsmedien B. Ausgangsgrößen des Simulationsmodells 41 bzw. des digitalen Prozess-Zwillings 40 sind Werte von Kennzahlen der Produktqualität Q (z.B. Reinheit, Homogenität) und Werte für messbare Zustandsgrößen wie beispielsweise der Temperatur T. T steht hier stellvertretend für weitere Zustandsgrößen wie Durchfluss, Druck, Füllstand, etc. der Produktionsanlage in Abhängigkeit von den Eingangsgrößen.

Dem Simulationsmodell 41 liegt dabei üblicherweise ein mathematisches Modell des Prozessverhaltens zugrunde, das auf einer rigorosen Modellbildung basiert, ausgehend von physikalischen, chemischen und thermodynamischen Gesetzmäßigkeiten. Vorzugsweise ist das Simulationsmodell 41 ein nichtlineares Modell.

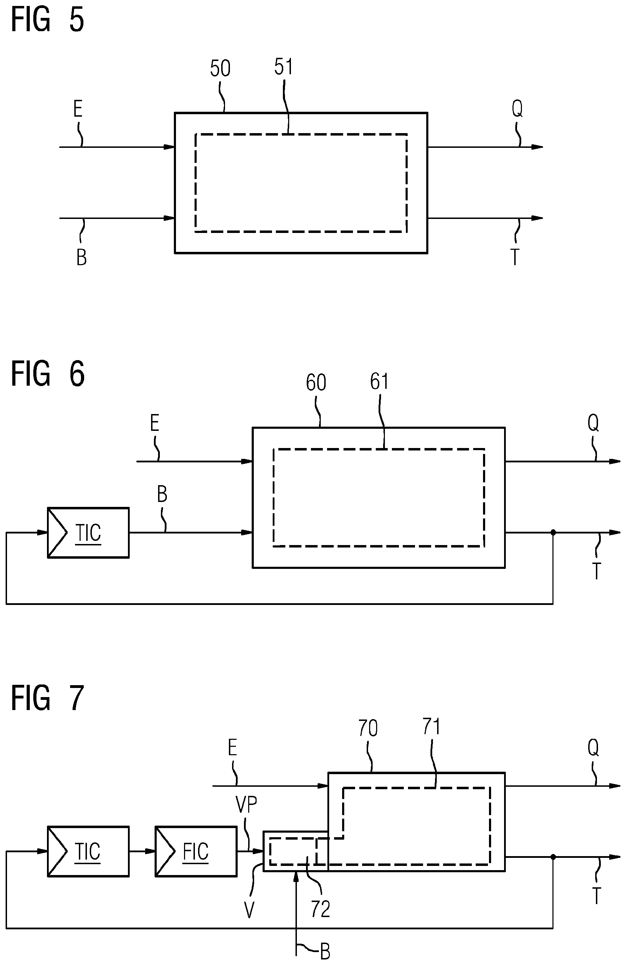

In dem dritten Schritt 30 c) wird gemäß FIG 5 ein stationäres druckgetriebenes Simulationsmodell 51 des Prozesses aus dem stationären flussgetriebenen Simulationsmodell 41 erzeugt und daraus ein digitaler Prozess-Zwilling 51 erzeugt. Es wird also auf eine druckgetriebene Simulation umgestellt, die eher dem physikalischen Prinzip von Ursache und Wirkung entspricht. Beispielsweise wird ein flüssiges oder gasförmiges Edukt aus einer Versorgungsleitung mit definiertem Druck bezogen, und der Durchfluss in jeder Komponente des Flussnetzes ergibt sich aus Druckdifferenz und Strömungswiderstand. Vorzugsweise ist auch das Simulationsmodell 51 ein nichtlineares Modell.

Die in den Schritten 30 b) und 30 c) erzeugten Simulationsmodelle 41, 51 bzw. die digitalen Prozess-Zwillinge 40, 50 werden für eine verfahrenstechnische Auslegung der Produktionsanlage verwendet und die Produktionsanlage wird dann entsprechend dieser Auslegung physikalisch realisiert.

In dem Schritt 30 d) werden nun Rohrleitungs- und Instrumentierungs-Planungsdaten (z.B. aus einem R&I-Diagramm, engl. P&I-Diagram), insbesondere zu Art und Position von Sensoren und Aktoren, der Produktionsanlage empfangen und in dem Schritt 30 e) ein dynamisches druckgetriebenes Simulationsmodell 61 des Prozesses aus dem stationären druckgetriebenen Simulationsmodell 51 und den Rohrleitungs- und Instrumentierungs-Planungsdaten erzeugt. Vorzugsweise ist auch das Simulationsmodell 61 ein nichtlineares Modell.

Von Vorteil kommt hierbei ein Simulationswerkzeug zum Einsatz, das eine Umschaltung zwischen stationärer und dynamischer Simulation ermöglicht, wie beispielsweise "gPROMS Process" von Siemens Process Systems Engineering Ltd..

Sobald beispielsweise die dynamische Simulation angewählt wird, öffnet sich dann zu jeder Modell-Komponente ein Parametrierdialog, um die zusätzlichen Parameter zu spezifizieren, die für eine dynamische Simulation erforderlich sind, beispielsweise Volumina von Reaktoren und Tanks, Wärmespeicherkapazitäten, Wärmeübergänge etc. Außerdem ist für eine dynamische Simulation eine Spezifikation von Anfangsbedingungen erforderlich.

Wie schematisch anhand FIG 6 dargestellt ist, kann ein derartiges dynamisches druckgetriebenes Simulationsmodell 61 besonders vorteilhaft in einem digitalen Prozess-Zwilling 60 zur Entwicklung und Validierung von Regelungskonzepten verwendet werden, wobei Folgeregelkreise aber noch nicht berücksichtigt werden. TIC steht hierbei für einen Temperaturregler für das Betriebsmedium B, stellvertretend für alle zu validierenden Regler in der Anlage.

Ein Regler, beispielsweise ein Temperaturregler für das Betriebsmedium, greift in vielen Fällen jedoch nicht direkt auf einen Aktor zu, sondern auf einen Folgeregler, beispielsweise einen Durchflussregler, der über ein Ventil einen Durchfluss des Betriebsmediums B steuert.

Um auch Folgeregelkreise zu berücksichtigen, wird in dem Schritt 30 f) das dynamische druckgetriebene Simulationsmodell 61 des Prozesses um Aktoren von Folgeregelkreisen der Anlage erweitert und - wie in FIG 7 dargestellt - ein erstes erweitertes dynamisches druckgetriebenes Simulationsmodell 71 des Prozesses gewonnen. Dieses Simulationsmodell 71 ist Bestandteil eines digitalen Prozess-Zwillings 70 zur erweiterten Entwicklung und Validierung von Regelungskonzepten. Der Temperaturregler TIC wirkt dabei über einen Durchflussregler FIC auf ein Ventil V ein, über das der Durchfluss von Betriebsmedium B steuerbar ist. Der Durchflussregler FIC erzeugt hierzu einen Sollwert VP für eine Position des Ventils V. Von Vorteil ist auch das Simulationsmodell 71 ein nichtlineares Modell.

Da in Durchfluss-Regelkreisen meist nur geringe Verzögerungen auftreten (Ventil-Laufzeit, Massen-Trägheit des Mediums, Tiefpassfilter im Sensor) kann hier oft mit Vereinfachungen und Standard-Annahmen gearbeitet werden. Beispielsweise wird davon ausgegangen, dass der Temperatur-Regler TIC mit einer Standard-Verzögerung den Massenstrom B der Materialfluss-Quelle für das Betriebsmedium ansteuern kann. Bei dieser Modellierungstiefe ist also noch kein explizites strömungsmechanisches Modell für den Folgeregelkreis mit Ventil und Durchflussregler in dem Simulationsmodell 71 erforderlich, sondern es wird nur ein vereinfachtes Modell 72 für das Ventil V in das Simulationsmodell 71 integriert.

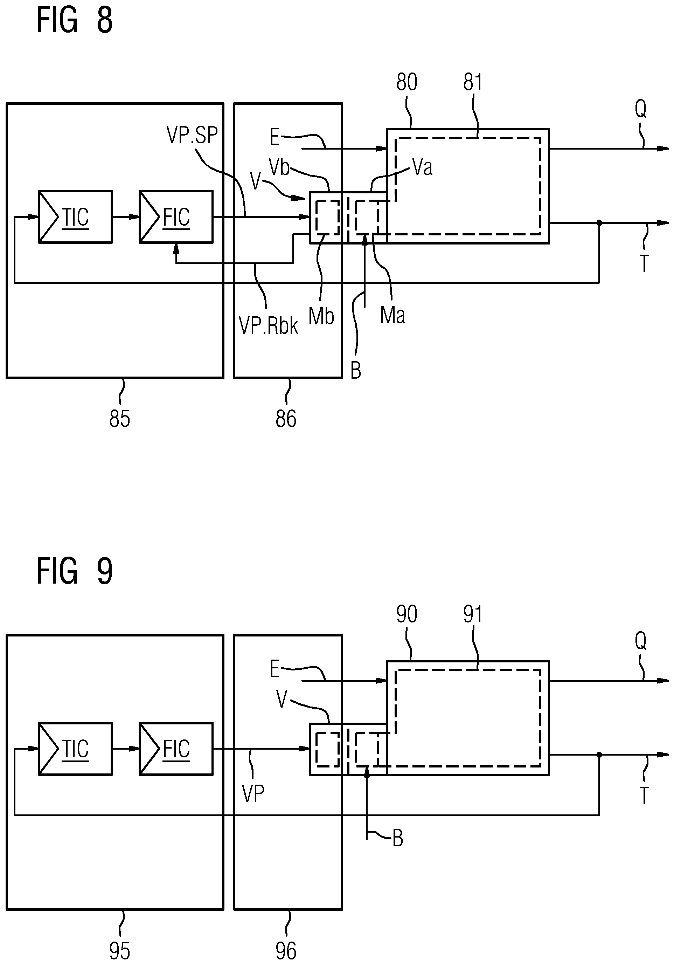

Wie in FIG 8 dargestellt, kann das um Aktoren von Folgeregelkreisen erweiterte dynamische druckgetriebene Simulationsmodell aber auch explizite strömungsmechanische Modelle der Aktoren umfassen. Ein derartiges erweitertes Simulationsmodell ist in FIG 8 mit 81 bezeichnet und ist Bestandteil eines digitalen Prozess-Zwillings 80 für eine virtuelle Inbetriebnahme der Anlage. Vorzugsweise ist auch das Simulationsmodell 81 ein nichtlineares Modell.

Bei den Aktoren der Folgeregelkreise werden dabei strömungsmechanische und steuerungstechnische Eigenschaften unterschieden, hier am Beispiel des Ventils V mit Va (strömungsmechanisch) und Vb (steuerungstechnisch) unterschieden. Die strömungsmechanischen Eigenschaften Va werden durch ein Modell Ma und die steuerungstechnischen Eigenschaften werden durch ein Modell Mb beschrieben.

Das Modell Mb ist Bestandteil des Simulationsmodells 81 und das Modell Mb ist Bestandteil eines nachfolgend näher beschriebenen digitalen Zwillings 86 der Instrumentierung.

Für eine virtuelle Inbetriebnahme der Anlage wird ein Prozess-Simulations-Tool, welches das Simulationsmodell 81 zum Ablauf bringt, mit der realen (originalen) Steuerungs-Software des Prozessleitsystems 85 gekoppelt. Die reale (originale) Steuerungs-Software läuft dabei auf einer realen oder einer virtuellen Automatisierungs-Hardware.

Das dynamische druckgetriebene Simulationsmodell kann dabei auch schon um PID-Regler der Regelkreise erweitert sein (siehe Schritt 30g) im Verfahrensablauf von FIG 3). Die PID-Regler werden für diesen Anwendungsfall aber meist nicht gebraucht Am besten werden sie im Modell belassen und in einen Nachführbetrieb gesetzt. Der Stellwert für den Nachführbetrieb kommt vom entsprechenden Regler im Prozessleitsystem, der damit die Kontrolle über die Prozess-Simulation übernimmt.

Für eine virtuelle Inbetriebnahme ist eine genauere Abbildung der Feldebene erforderlich. Der Simulator soll auch Rückmeldungen von Aktoren erzeugen (z.B. Stellungsrückmeldung von Ventilen, Status von Motoren) und ggf. ein Statussignal für Sensoren erzeugen. Solche Funktionalitäten sind mit Hilfe von entsprechenden leitsystemorientierten Aktor- und Sensormodellen hochgradig standardisierbar, gehen aber oft über den Funktionsumfang typischer verfahrenstechnischer Simulations-Tools hinaus. Daher ist es vorteilhaft, zwischen Prozess-Simulator (d.h. das Simulationsmodell 81) und das Prozessleitsystem 85 eine Zwischenschicht einzuziehen, welche die Feldebene repräsentiert und als ein digitaler Instrumentierungs-Zwilling ("Digital Instrumentation Twin") angesehen werden kann, der in FIG 8 mit dem Bezugszeichen 86 bezeichnet ist. Idealerweise wird diese Zwischenschicht semiautomatisch aus der Konfiguration des Prozessleitsystems 85 abgeleitet. Mit VP.SP ist dabei ein Sollwert für eine Ventilposition und mit VP.Rbk ist ein gemessener Istwert für die Ventilposition bezeichnet.

Durch die virtuelle Inbetriebnahme kann die Steuerungs-Software des Leitsystems auf Fehlerfreiheit getestet und im Fall eines Fehlers korrigiert werden. Informationen über einen Fehler oder über eine Fehlerfreiheit können dann auf einer Ausgabeeinheit (z.B. einer Anzeige) zur Ausgabe gebracht werden.

Wie aus FIG 9 ersichtlich ist, kann die Gesamtarchitektur von FIG 8 nach der virtuellen Inbetriebnahme dann auch für ein Bediener-Trainings-System (Operator Training System, OPS) genutzt werden. Idealerweise wird dabei die Leitsystem-Hardware auf einem PC emuliert ("virtuelle Steuerung, virtueller Controller") und es werden die originalen grafischen Nutzeroberflächen einer Bedien- und Beobachtungs-Software des Leitsystems verwendet. Diese Kombination aus virtueller Steuerung und originaler Bedien- und Beobachtungs-Software des Prozessleitsystems ist in FIG 9 mit 95 bezeichnet. Der digitale Prozess-Zwilling 90 bzw. das Simulationsmodell 91 von FIG 9 basiert auf dem digitalen Prozess-Zwilling 80 bzw. dem Simulationsmodell 81 von FIG 8. Das Simulationsmodell 91 ist folglich mit der Bedien- und Beobachtungs-Software des Leitsystems gekoppelt. Von Vorteil ist auch das Simulationsmodell 91 ein nichtlineares Modell.

Diese Art von Bediener-Trainings-System vermittelt den Schulungsteilnehmern ein realistisches "Look&Feel" der Leitwarte in Echtzeit. Aus Sicht des Anlagenfahrers macht es kaum einen Unterschied, ob er den realen Prozess oder dessen digitalen Prozess-Zwilling bedient. Alle Aufgaben, die von Anlagenfahrern in der Leitwarte bewältigt werden müssen, können damit realitätsnah geübt werden, insbesondere auch Szenarien, die an der echten Anlage selten vorkommen oder mit hohen Risiken verbunden sind.

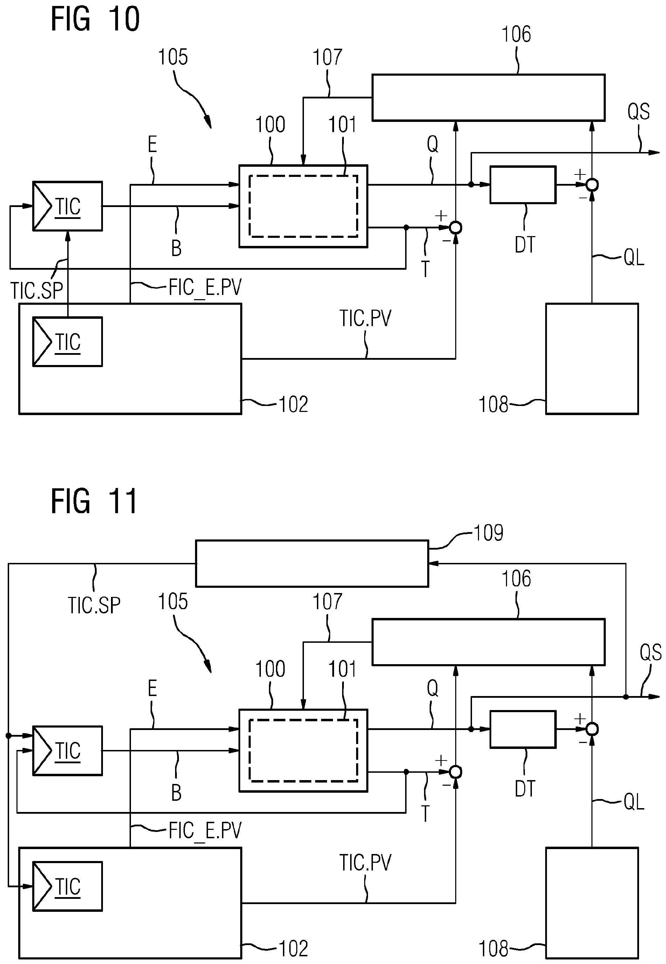

Gemäß FIG 10 kann das in dem Schritt 30 e), 30 f) oder 30 g) erzeugte Simulationsmodell 61, 71 bzw. 81 in einer betriebsparallelen Echtzeit-Simulation für einen modellbasierten Soft-Sensor 105 der Anlage verwendet werden. Das Simulationsmodell ist dabei mit 101 bezeichnet und Bestandteil eines digitalen Prozess-Zwillings 100.

Das Modell 101 wird mit denselben Werten aller Eingangsvariablen versorgt, wie sie gerade am realen Prozess bzw. realen Prozessleitsystem 102 anstehen, beispielsweise alle Zuläufe von Edukten und Betriebsmedien in der Anlage. Alle Messwerte des realen Prozesses, hier durch den Messwert TIC.PV der Temperatur repräsentiert, werden mit den entsprechenden vom Modell 101 berechneten Zustandsvariablen, hier repräsentiert durch die Temperatur T, verglichen. Erkannte Abweichungen werden beispielsweise in einen EKF-Algorithmus (EKF = Extended Kalman Filter) 106 eingespeist, um ausgewählte unsichere Modell-Zustandsvariablen oder zeitvariante Modellparameter des Modells 101 an den aktuellen Zustand des realen Prozesses anzupassen. Diese Anpassung ist durch einen Pfeil 107 repräsentiert. Das Simulationsmodell 101 ist (im Gegensatz zum realen Prozess) völlig transparent, so dass jede Variable, die für die Prozessführung interessant sein könnte, online aus dem Modell 101 abgelesen werden kann, auch wenn sie am realen Prozess nicht direkt messbar ist. Mit TIC.SP ist hierbei ein Sollwert für den Temperaturregler TIC und mit FIC E.PV sind Istwerte für den zugeführten Fluss an Edukten bezeichnet.

Ein typischer Einsatzfall sind Kenngrößen der Produktqualität oder Stoff-Konzentrationen, die online nicht messbar sind, sondern nur sporadisch mit Hilfe von Laborproben ermittelt werden. Die vom Modell 101 berechneten Kenngrößen sind dagegen online verfügbar und können in Regelkreisen anstelle von realen Sensor-Messwerten genutzt werden. Wenn Ergebnisse QL für Kenngrößen aus Laborproben von einer Laboranalyse 108 eintreffen, werden diese zusätzlich für den Zustandsabgleich im Soft-Sensor 105 genutzt, wobei durch ein Zeitglied DT Zeitverzögerungen bei der Laboranalyse berücksichtigt werden.

Das dynamische Prozessmodell 101 für einen solchen Soft-Sensor 105 muss das Verhalten der automatisierten Anlage realistisch darstellen. Die PID-Regler sind deshalb hierbei vorzugsweise Teil des Prozessmodells, d.h. es kommt vorzugsweise ein dynamisches druckgetriebenes Simulationsmodell zum Einsatz, das die PID-Regler der Regelkreise umfasst (siehe Schritt 30g) in FIG 3).

Es ist darauf zu achten, dass die geschlossenen Regelkreise im Zusammenspiel von Regelstrecke und Regler sich zeitlich korrekt verhalten. Dies erfordert eine sorgfältige Parametrierung sowohl der verfahrenstechnischen Modell-Komponenten als auch der Regler im Modell, die mit Hilfe von zahlreichen offline Simulationen des Prozessmodells ohne EKF-Solver durchgeführt wird. Das Modell wird mit Zeitverläufen der Eingangsvariablen aus realen historischen Datensätzen versorgt und der Verlauf der Ausgangsvariablen mit den historischen Daten verglichen. Falls erforderlich wird zunächst das stationäre Verhalten und dann das dynamische Verhalten angepasst.

Besondere Aufmerksamkeit ist auf die Umschaltung von Regler-Betriebsarten zu richten. Falls diese im Betrieb relevant sind, muss nicht nur der Sollwert, sondern auch die Betriebsart und ggf. der Handwert aus dem Leitsystem in die entsprechenden Regler des Modells eingelesen werden. Spätestens für diesen Anwendungsfall muss das Simulationsmodell auch eine Repräsentation der Aktoren (z.B. Ventile) aufweisen, damit Hand-Stellwerte überhaupt vom Modell verarbeitet werden können.

Das dynamische Modell 101 des automatisierten Prozesses, mit PID-Reglern und mit an den realen Prozesszustand angepassten Parametern, d.h. das für den Soft-Sensor 105 entwickelte Modell 101, ist genau die richtige Modellform für eine nichtlineare modellbasierte prädiktive Regelung (MPC). Gemäß FIG 11 wird das Simulationsmodell 101 in einer betriebsparallelen Echtzeit-Simulation in Kombination mit einem nichtlinearen modellbasierten prädiktiven Regler 109 verwendet. Der Regler 109 empfängt eingangsseitig die von dem Soft-Sensor 105 bzw. dem Modell 101 berechneten Werte Q für die Qualität und berechnet daraus Sollwerte TIC.SP für die Temperatur, die an das Prozessleitsystem 102 übergeben werden.

Einige PID-Regler der Basisautomatisierung des Prozessleitsystems 102 werden jetzt in einer Kaskadenschaltung als Folgeregler angesteuert, mit dem Regler 109 als Führungsregler. Im Gegensatz zu handelsüblichen linearen prädiktiven Reglern mit Blackbox-I/O-Modellen sind jetzt keine zeitaufwändigen Sprungversuche in der Anlage mehr erforderlich, um ein lineares dynamisches Blackbox Modell aus Messdaten zu identifizieren. Das (nichtlineare) dynamische Modell 101 kann das Verhalten der Anlage nicht nur in der Umgebung eines Arbeitspunktes beschreiben, sondern auch bei Lastwechseln, Produkt-Sortenwechseln, An- oder Abfahrvorgängen. Wenn solche Anforderungen im Produktionsbetrieb gar nicht bestehen, kann das rigorose dynamische Modell 101 numerisch linearisiert und für einen kostengünstigeren linearen MPC (ggf. auch direkt im Prozessleitsystem 102 integriert) genutzt werden.

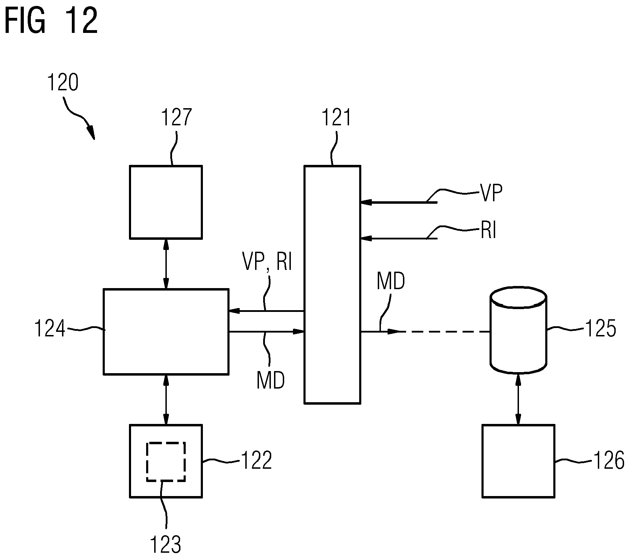

FIG 12 zeigt in schematischer Darstellung ein erfindungsgemäßes System 120 zur Erzeugung von Simulationsmodellen für einen digitalen Zwilling eines Prozesses einer verfahrenstechnischen Produktionsanlage für ein Produkt. Das System 120 umfasst eine Schnittstelle 121 (z.B. eine Schnittstelle zum Internet, eine USB-Schnittstelle), die ausgebildet ist
a) zum Empfang von Verfahrensfluss-Planungsdaten VP und von Rohrleitungs- und Instrumentierungs-Planungsdaten RI der Produktionsanlage und
b) zur Ausgabe von Modelldaten MD von jedem der Simulationsmodelle zu deren Speicherung in einem Datenspeicher 125.

Das System 120 umfasst hierzu einen ersten Speicher 122 umfassend Befehle 123 und einen Prozessor 124. Der Prozessor 124 ist mit dem ersten Speicher gekoppelt 122 und ausgebildet, bei Ausführung der Befehle die Schritte 30a) bis 30g) des Verfahrens nach FIG 3 auszuführen. In dem Speicher 122 oder in einem zweiten Speicher 127 können die empfangenen Verfahrensfluss-Planungsdaten VP und Rohrleitungs- und Instrumentierungs-Planungsdaten RI sowie die erzeugten Modelldaten MD zwischengespeichert werden.

Jedes der Simulationsmodelle ermittelt dabei Kennzahlen einer Qualität des Produktes und messbare Zustandsgrößen der Produktionsanlage in Abhängigkeit von der Produktionsanlage zugeführten Stoffströmen von Edukten und von Betriebs-Medien. Die Modelldaten sind derart erzeugt (z.B. hinsichtlich Auswahl, Inhalt und Struktur), dass anhand der Modelldaten die Simulationsmodelle durch eine Simulationssoftware zur Ausführung bringbar sind.

Der Datenspeicher 125 und die Simulationssoftware 126 können dabei ein integrierter Bestandteil des Systems 120 sein, oder auch getrennt davon. Beispielsweise kann sich das System 120 auf einer internetbasierenden digitalen Plattform befinden und die Erzeugung der Simulationsmodelle von einem Service-Provider als eine Dienstleistung angeboten werden. In diesem Fall sind die Komponenten 121, 122, 124 und 127 unter Kontrolle des Service Providers und befinden sich auf der Plattform. Die Komponenten 125 und 126 sind dagegen unter Kontrolle des Kunden und befinden sich lokal bei ihm vor Ort oder ebenfalls auf dieser oder einer anderen Plattform. Die Kunden laden sich dann die erzeugten Modelldaten von dem System 120 und speichern sie in ihrem Datenspeicher 125. Von dort aus können sie dann von dem Simulations-Tool 126 ausgelesen und die Simulationsmodelle zur Ausführung gebracht werden.

Alternativ kann das System 120, der Datenspeicher 125 und das Simulationstool 126 auch ein integriertes, beispielsweise PC basiertes, Gesamtsystem sein.

Vorzugsweise erlaubt das System 120 eine Umschaltung zwischen einer stationären und einer dynamischen Simulation sowie eine Umschaltung zwischen einer flussgetriebenen und einer druckgetriebenen Simulation.

Zusammenfassend ermöglicht die Erfindung eine durchgängige Nutzung eines Prozess-Master-Modells (hier des stationären flussgetriebenen Simulationsmodells) für einen digitalen Prozess-Zwilling. Dieses Modell wird kontinuierlich weiterentwickelt und auf den jeweiligen Anwendungsfall angepasst, ohne Informationen aus früheren Phasen zu verlieren oder erneut manuell einpflegen zu müssen. Die Investition in die Entwicklung eines digitalen Prozess-Zwillings kann jetzt über mehrere Anwendungsfälle amortisiert werden. Damit können modellbasierte Lösungen auch in Anwendungsfeldern attraktiv werden, in denen sich der Aufwand für die Modellentwicklung mit einem einzigen Anwendungsfall bisher nicht rechtfertigen lässt. Generell verbessert sich dadurch die Relation zwischen Nutzen und Aufwand für modellbasierte Lösungen.

## Patentansprüche

1. Computerimplementiertes Verfahren (30) zur Erzeugung von Simulationsmodellen (41, 51, 61, 71) für einen digitalen Zwilling (40, 50, 60, 70) eines Prozesses (3) einer verfahrenstechnischen Produktionsanlage (1) für ein Produkt (S) umfassend:
a) Empfangen von Verfahrensfluss-Planungsdaten (VP) des Prozesses (3) der Produktionsanlage (1),
b) Erzeugen eines stationären flussgetriebenen Simulationsmodells (41) des Prozesses (3) aus den Verfahrensfluss-Planungsdaten (VP),
c) Erzeugen eines stationären druckgetriebenen Simulationsmodells (51) des Prozesses (3) aus dem stationären flussgetriebenen Simulationsmodell (41),
d) Empfangen von Rohrleitungs- und Instrumentierungs-Planungsdaten (RI),
e) Erzeugen eines dynamischen druckgetriebenen Simulationsmodells (61) des Prozesses aus dem stationären druckgetriebenen Simulationsmodell (51) und den Rohrleitungs- und Instrumentierungs-Planungsdaten (RI), wobei das dynamische druckgetriebene Simulationsmodell Sensoren und Aktoren von Regelkreisen der Produktionsanlage (1) umfasst,
wobei jedes der Simulationsmodelle (41, 51, 61, 71) messbare Zustandsgrößen (T) der Produktionsanlage (1) in Abhängigkeit von der Produktionsanlage (1) zugeführten Stoffströmen von Edukten (E) und von Betriebs-Medien (B) ermittelt, und
wobei Modelldaten (MD) von jedem der Simulationsmodelle (41, 51, 61, 71) derart erzeugt und in einem Datenspeicher (125) abgespeichert werden, dass durch eine Simulationssoftware (126) die Modelldaten (MD) aus dem Datenspeicher auslesbar und anhand der ausgelesenen Modelldaten (MD) die Simulationsmodelle (41, 51, 61, 71) zur Ausführung bringbar sind.

2. Verfahren nach Anspruch 1, wobei jedes der Simulationsmodelle (41, 51, 61, 71) Kennzahlen (Q) einer Qualität des Produktes (S) in Abhängigkeit von der Produktionsanlage (1) zugeführten Stoffströmen von Edukten (E) und von Betriebs-Medien (B) ermittelt.

3. Verfahren nach Anspruch 1 oder 2, wobei das in dem Schritt e) erzeugte dynamische druckgetriebene Simulationsmodell Aktoren (VB) von Folgeregelkreisen, insbesondere strömungsmechanische Modelle von Aktoren (V) von Folgeregelkreisen, der Regelkreise umfasst oder in einem weiteren Schritt f) um diese erweitert wird.

4. Verfahren nach einem der Ansprüche 1 bis 3, wobei das in dem Schritt e) oder f) erzeugte dynamische druckgetriebene Simulationsmodell PID-Regler der Regelkreise umfasst oder in einem weiteren Schritt g) um diese erweitert wird.

5. Verfahren nach Anspruch 1 oder 2, wobei das in dem Schritt b) und/oder c) erzeugte Simulationsmodell für eine verfahrenstechnische Auslegung der Produktionsanlage verwendet und die Produktionsanlage entsprechend dieser Auslegung physikalisch realisiert wird.

6. Verfahren nach einem der vorgehenden Ansprüche, wobei das in dem Schritt e), f) oder g) erzeugte Simulationsmodell für eine Entwicklung und Validierung von Regelungskonzepten verwendet und die Regelung der Produktionsanlage entsprechend dieser Auslegung physikalisch realisiert wird.

7. Verfahren nach einem der vorgehenden Ansprüche, wobei das in dem Schritt e), f) oder g) erzeugte Simulationsmodell für eine virtuelle Inbetriebnahme der Anlage verwendet und hierzu mit einer Steuerungs-Software der Anlage gekoppelt wird, um diese auf Fehlerfreiheit zu testen.

8. Verfahren nach einem der vorgehenden Ansprüche, wobei das in dem Schritt e), f) oder g) erzeugte Simulationsmodell für ein Training von Bedienpersonal der Anlage verwendet und hierzu mit einer Bedien- und Beobachtungs-Software der Anlage gekoppelt wird.

9. Verfahren nach einem der vorgehenden Ansprüche, wobei das in dem Schritt e), f) oder g) erzeugte Simulationsmodell für einen modellbasierten Soft-Sensor der Anlage verwendet wird.

10. Verfahren nach einem der vorgehenden Ansprüche, wobei das in dem Schritt e), f) oder g) erzeugte Simulationsmodell für eine modellbasierte prädiktive Regelung der Anlage verwendet wird.

11. Verfahren nach einem der vorgehenden Ansprüche, wobei das in dem Schritt e), f) oder g) erzeugte Simulationsmodell für ein Assistenzsystem für den Bediener der Anlage verwendet wird und hierzu mit einer Steuerungs-Software der Anlage gekoppelt wird.

12. System zur Erzeugung von Simulationsmodellen (41, 51, 61, 71) für einen digitalen Zwilling (40, 50, 60, 70) eines Prozesses (3) einer verfahrenstechnischen Produktionsanlage (1) für ein Produkt (S), umfassend
- eine Schnittstelle (121), die ausgebildet ist
a) zum Empfang von Verfahrensfluss-Planungsdaten (VP) und von Rohrleitungs- und Instrumentierungs-Planungsdaten (RI) der Produktionsanlage (1) und
b) zur Ausgabe von Modelldaten (MD) von jedem der Simulationsmodelle (41, 51, 61, 71) zu deren Speicherung in einem Datenspeicher (125),
- einen Speicher (122), umfassend Befehle (123),
- einen Prozessor (124), der mit dem Speicher (122) gekoppelt ist und bei Ausführung der Befehle (123) ausgebildet ist, die Schritte a) bis e), vorzugsweise auch die weiteren Schritte f) und/oder g), des Verfahrens nach einem der Ansprüche 1 bis 4 auszuführen, wobei jedes der Simulationsmodelle (41, 51, 61, 71) messbare Zustandsgrößen (T) der Produktionsanlage (1), vorzugsweise auch Kennzahlen (Q) einer Qualität des Produktes (S), in Abhängigkeit von der Produktionsanlage (1) zugeführten Stoffströmen von Edukten (E) und von Betriebs-Medien (B) ermittelt, und wobei die Modelldaten (MD) derart erzeugt sind, dass anhand der Modelldaten (MD) die Simulationsmodelle (41, 51, 61, 71) durch eine Simulationssoftware (126) zur Ausführung bringbar sind.

13. Computerprogramm, umfassend Befehle, die bei der Ausführung des Programms durch einen Computer diesen veranlassen, das Verfahren nach einem der Ansprüche 1 bis 4 auszuführen

14. Computerlesbares Speichermedium umfassend Befehle, die bei der Ausführung durch einen Computer diesen veranlassen, das Verfahren nach einem der Ansprüche 1 bis 4 auszuführen.
